# EUROPÄISCHE PATENTSCHRIFT

(11) **EP 2 523 209 B1**
(45) Veröffentlichungstag und Bekanntmachung des Hinweises auf die Patenterteilung: **08.03.2017**
(21) Anmeldenummer: 12179539.7
(22) Anmeldetag: 23.04.2010
(51) Int. Cl.: H01L 21/67, H01L 21/00, H01L 21/673, H01L 21/687, B32B 38/10, B32B 37/00, B32B 38/00, B32B 43/00

(54) **Vorrichtung und Verfahren zum Ablösen eines Produktsubstrats von einem Trägersubstrat**
Device and method for releasing a product substrate from a holder substrate
Dispositif et procédé de séparation d'un substrat de produit et d'un substrat de support

(43) Veröffentlichungstag der Anmeldung: 14.11.2012
(62) Teilanmeldung aus: 10004313.2
(73) Patentinhaber: EV Group GmbH, 4782 St. Florian am Inn (AT)
(72) Erfinder: Lindner, Friedrich Paul, 4780 Schärding/Inn (AT); Burggraf, Jürgen, 4780 Schärding/Inn (AT)
(74) Vertreter: Schweiger, Johannes

(56) Entgegenhaltungen:
- DE-A1- 19 734 635
- JP-A- 6 275 717
- US-A1- 2004 166 653
- US-A1- 2007 295 458
- US-A1- 2009 305 617
- US-B1- 6 342 434

## Beschreibung

Die Erfindung betrifft eine Vorrichtung gemäß Anspruch 1 und ein Verfahren gemäß Anspruch 4 zum Ablösen eines Produktsubstrats von einem Trägersubstrat.

Das Rückdünnen von Produktsubstraten ist in der Halbleiterindustrie häufig erforderlich und kann mechanisch und/oder chemisch erfolgen. Zum Rückdünnen werden die Produktsubstrat in der Regel auf einen Träger vorübergehend fixiert, wobei es für die Fixierung verschiedene Methoden gibt. Als Trägermaterial werden beispielsweise Folien, Glassubstrate oder Siliziumwafer verwendet.

Die Druckschrift US 2009/305617 A1 zeigt eine Trägervorrichtung zur Aufnahme von Wafern mit einer Zuführkammer für Lösungsmittel zur Reduzierung der Bondstärke. Weitere Vorrichtungen sind in der US 2007/295458 A1 und der DE 197 34 635 A1 gezeigt.

In Abhängigkeit von den verwendeten Trägermaterialien und der verwendeten Verbindungsschicht zwischen Träger und Produktsubstrat sind verschiedene Verfahren zur Auflösung oder Zerstörung der Verbindungsschicht bekannt, wie beispielsweise die Verwendung von UV-Licht, Laserstrahlen, Temperatureinwirkung oder Lösungsmittel. Das Ablösen stellt sich zunehmend als einer der kritischsten Prozessschritte dar, da die dünnen Substrate mit Substratdicken von wenigen µm beim Ablösen/Abziehen leicht brechen oder durch die für den Vorgang des Ablösens notwendigen Kräfte Schaden erleiden. Darüber hinaus haben die dünnen Substrate kaum bis keine Formstabilität und rollen sich typischerweise ohne Stützmaterial ein. Während der Handhabung der rückgedünnten Wafer ist mithin eine Fixierung und Unterstützung der Wafer praktisch unumgänglich.

Es ist daher die Aufgabe der vorliegenden Erfindung, eine Vorrichtung und ein Verfahren anzugeben, um ein Produktsubstrat möglichst zerstörungsfrei und einfach von einem Träger zu lösen.

Diese Aufgabe wird mit den Merkmalen der Ansprüche 1 und 4 gelöst. Vorteilhafte Weiterbildungen der Erfindung sind in den Unteransprüchen angegeben.

Den Ausführungsbeispielen liegt der Gedanke zugrunde, eine gattungsgemäße Vorrichtung beziehungsweise ein gattungsgemäßes Verfahren dadurch weiterzubilden, indem Lösungsmittel in einen durch den Filmrahmen und den daran befestigten Film gebildeten Lösungsmittelbehälter eingebracht wird. Durch die Elastizität oder Flexibilität des auf dem Filmrahmen montierten Films ist es gleichzeitig möglich, den Lösungsmittelbehälter volumenveränderlich zu gestalten und die Elastizität oder Flexibilität des Films wird erfindungsgemäß außerdem genutzt, um das Produktsubstrat schonend und vom Rand des Produktsubstrats her abzulösen. Auf diese Weise steht das Produktsubstrat unmittelbar nach dem Abtrennen für weitere Prozessschritte zur Verfügung und ist durch den Film und den Filmrahmen geschützt. Viele Prozessschritte können direkt an dem filmrahmenmontierten Produktsubstrat durchgeführt werden.

Mit Produktsubstrat ist ein Produktsubstrat, beispielsweise ein Halbleiterwafer, gemeint, das üblicherweise auf eine Dicke zwischen 0,5 µm und 250 µm gedünnt ist, wobei die Tendenz zu immer dünneren Produktsubstraten geht. Besonders effektiv arbeitet die vorliegende Erfindung mit Produktsubstraten, die selbst eine ähnliche Flexibilität wie der am Filmrahmen montierte Film aufweisen. Das Produktsubstrat wird bei der erfindungsgemäßen Vorrichtung beziehungsweise dem erfindungsgemäßen Verfahren von dem Trägersubstrat abgeschält, insbesondere konzentrisch vom Umfang des Produktsubstrats ausgehend.

Als Träger wird beispielsweise ein Trägersubstrat mit einer Dicke zwischen 50 µm und 5.000 µm, insbesondere zwischen 500 µm und 1000 µm verwendet.

Als Verbindungsschicht kommt ein Kleber, beispielsweise ein lösbarer Kleber, insbesondere ein Thermoplast in Frage, der beispielsweise selektiv in einem Randbereich des Träger-Produktsubstrat-Verbundes, insbesondere in einer Randzone von 0,1 bis 20 mm, aufgebracht wird. Alternativ kann der Kleber vollflächig aufgebracht werden, wobei die Klebekraft im Zentrum durch eine haftreduzierende Schicht, beispielsweise ein Fluorpolymer, vorzugsweise Teflon, reduziert sein kann.

Als Aufnahmeeinrichtung eignet sich besonders ein Chuck, insbesondere ein Spinner Chuck zur Aufnahme des Trägersubstrats, insbesondere mittels Unterdruck, beispielsweise an Saugbahnen, Bohrungen oder Saugnäpfen. Alternativ ist eine mechanische Aufnahme, beispielsweise durch seitliche Klammern, denkbar. In einer weiteren, alternativen Ausgestaltung erfolgt die Aufnahme elektrostatisch.

Die Ablösungsmittel umfassen den auf den Filmrahmen montierten Film und eine den Filmrahmen aufnehmende und kraftbeaufschlagende Filmrahmenaufnahme.

In einer vorteilhaften Ausführungsform ist vorgesehen, dass das Lösungsmittel im Wesentlichen erhitzungsfrei arbeitend ausgebildet ist. Das Lösungsmittel wird vorzugsweise bei Umgebungstemperatur eingesetzt. Auf diese Weise ist es möglich, auf jegliche Heizeinrichtung zu verzichten.

Indem das Lösungsmittel zur zumindest partiellen Lösung der durch die Verbindungsschicht bewirkten Verbindung zwischen dem Trägersubstrat und dem Produktsubstrat vorgesehen ist, wird das Ablösen durch die Ablösemittel mit Vorteil deutlich erleichtert.

Dadurch, dass das Lösungsmittel, insbesondere ein die Verbindungsschicht selektiv auflösendes, Fluidmittel zur zumindest partiellen Lösung der Verbindungsschicht umfasst, wird bei verschiedene Kleber umfassenden Verbindungsschichten ermöglicht, eine bestimmte Verbindungsschicht gezielt oder in definierten Regionen aufzulösen. Die chemische Auflösung der Verbindungssicht ist für das Produktsubstrat dabei besonders schonend und bei entsprechender Materialwahl kann die Auflösung auch sehr schnell erfolgen, insbesondere wenn nur Randbereiche des Produktsubstrats mit einer Verbindungsschicht versehen sind, so dass das Lösungsmittel von der Seite her schnell wirken kann. Auf diese Weise kann auf Perforierungen im Trägersubstrat und/oder Produktsubstrat verzichtet werden.

Soweit der Lösungsmittelbehälter derart ausgebildet ist, dass das Lösungsmittel zumindest am Beginn des Lösens der Verbindungsschicht, insbesondere ausschließlich, im Bereich eines Umfangs des Produktsubstrats wirkt, kann auf eine Einwirkung des Produktsubstrats und/oder Trägersubstrats von der Oberseite und/oder der Unterseite, insbesondere einem innerhalb des Seitenrandes liegenden Innenbereich des Produktsubstrats, verzichtet werden.

Erfindungsgemäß ist vorgesehen, dass die Ablösungsmittel eine auf das Trägersubstrat wirkende Kraft Fₛ und eine entgegen der Kraft Fₛ gerichtete, auf den Filmrahmen wirkenden Kraft F_{f} bewirkend ausgebildet sind. Hierdurch wird auf einfache und durch den Film besonders schonende Art und Weise das Ablösen bewerkstelligt. Die Kraft F_{f} wirkt am Umfang des Filmrahmens, an mindestens zwei, über den Umfang verteilten Stellen des Filmrahmens, wobei die Kräfte F_{f1} und F_{f2} erfindungsgemäß unterschiedlich gesteuert werden können, um das Produktsubstrat von der Seite her mit der größeren Kraft F_{f} abzulösen.

Dabei ist es von besonderem Vorteil, wenn der Film, insbesondere durch die Kraft Fs und die Kraft Ff, in einem zwischen dem Kontaktierungsflächenabschnitt und dem Befestigungsabschnitt liegenden Ablöseabschnitt spannbar ist. Hierdurch wird das Ablösen schonend am Umfang des Produktsubstrats bewirkt. Das Lösen durch das Lösungsmittel und das Ablösen durch die Kräfte Fₛ und F_{f} unterstützt sich dabei gegenseitig.

Gemäß einer vorteilhaften Ausführungsform ist vorgesehen, dass ein auf das Lösungsmittel und/oder die Verbindungsschicht einwirkender, insbesondere am Film anliegender und/oder in das Lösungsmittel im Lösungsmittelbehälter einbringbarer, Schwingungserzeuger vorgesehen ist. Einbringbar umfasst sowohl einen Oberflächenkontakt als auch ein zumindest teilweises Eintauchen. Dieser unterstützt das Lösen durch das Lösungsmittel und beschleunigt den Lösungsvorgang mindestens um den Faktor 2, bei optimierter Ausgestaltung um den Faktor 5, noch bevorzugter um den Faktor 10 bis 50. Vorzugsweise wirkt der Schwingungserzeuger durch Ultraschallwellen, insbesondere im Bereich des Kontaktierungsflächenabschnitts.

In einer weiteren vorteilhaften Ausführungsform ist der Lösungsmittelbehälter wannenförmig ausgebildet, wodurch mit einem minimalen Lösungsmittelverbrauch die Ablösung des Produktsubstrats erreicht werden kann.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1a:: Eine schematische Aufsicht auf einen aus Produktsubstrat, Trägersubstrat und Verbindungsschicht bestehenden Substratverbund auf einem Filmrahmen,
- Fig. 1b:: eine schematische Seitenansicht zu Figur 1a mit einer Detailansicht,
- Figur 2:: eine schematische Darstellung gemäß Figur 2 beim Einbringen des Lösungsmittels,
- Figur 3: eine schematische Darstellung eines Verfahrensausschnitts des Lösens der Verbindungsschicht,
- Figur 4:: eine schematische Darstellung eines erfindungsgemäßen Verfahrensschritts des Ablösens des Produktsubstrats vom Trägersubstrat.
- Figur 5:: eine schematische Darstellung eines alternativen erfindungsgemäßen Verfahrensschritts des Ablösens des Produktsubstrats vom Trägersubstrat.

In den Figuren sind gleiche Bauteile und Bauteile mit der gleichen Funktion mit den gleichen Bezugszeichen gekennzeichnet.

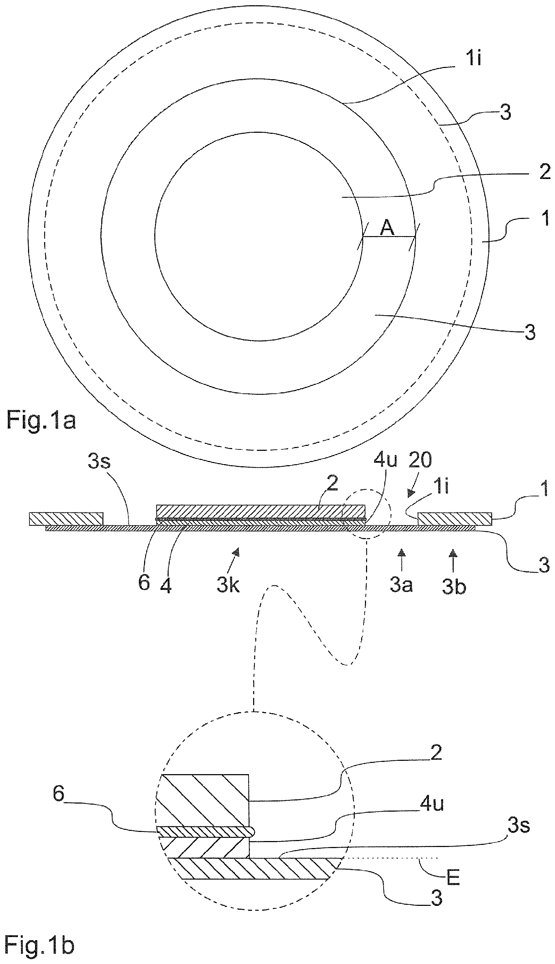

In Figur 1a ist ein in dieser Ausführungsform zumindest an einem Innenumfang 1i kreisrunder Filmrahmen 1 gezeigt, an dessen Unterseite gemäß der in Figur 1b gezeigten Schnittansicht ein Film 3 mit seiner Klebeschicht 3s konzentrisch zu dem Filmrahmen 1 aufgeklebt ist. Mit einem Radialabstand A zu dem Innenumfang 1i des Filmrahmens 1 ist innerhalb des Filmrahmens 1 ein Produktsubstrat-Trägersubstrat-Verbund auf der Klebeschicht 3s des Films 3 konzentrisch zu dem Filmrahmen 1 aufgeklebt. Der Produktsubstrat-Trägersubstrat-Verbund besteht aus einem am Film 3 haftenden Produktsubstrat 4, einem Trägersubstrat 2 und einer das Produktsubstrat 4 und das Trägersubstrat 2 verbindenden Verbindungsschicht 6. Die Durchmesser des Produktsubstrats 4 und des Trägersubstrats 2 sind im Wesentlichen identisch, während die Dicke des Produktsubstrats 4 geringer ist als die Dicke des Trägersubstrats 2.

Der Film 3 besteht aus einem im vorliegenden Fall kreisringförmigen Befestigungsabschnitt 3b, in welchem der Film 3 mit dem Filmrahmen 1 fixiert ist. Weiterhin besteht der Film 3 aus einem Kontaktierungsflächenabschnitt 3k, in welchem das Produktsubstrat 4 an der Klebeschicht 3s des Films 3 fixierbar ist. Zwischen dem Befestigungsabschnitt 3b und dem Kontaktierungsflächenabschnitt 3k liegt ein, insbesondere konzentrisch zu dem Befestigungsabschnitt 3b und dem Kontaktierungsflächenabschnitt 3k angeordneter Ablöseabschnitt 3a, der keine Klebefunktion aufweisen muss, dem aber eine erfindungsgemäß entscheidende Funktion zukommt. Der Ablöseabschnitt 3a erstreckt sich damit von einem Umfang 4u des Produktsubstrats 4 bis zu dem Innenumfang 1i des Filmrahmens 1, vorliegend als Radialabstand A bezeichnet. Das Verhältnis zwischen einer Dicke D des Filmrahmens 1 und des Abstands A beträgt im Vorteil mindestens 1:2 bis 1:50, insbesondere 1:5 bis 1:25.

In der in Figur 1b gezeigten Ausgangslage sind die den Film 3 kontaktierende Seite des Produktsubstrats 4 und die den Film 3 kontaktierende Seite des Filmrahmens 1 fluchtend und in einer Ebene E angeordnet. Die in den Figuren 1a und 1b gezeigten Teile werden auf einen bekannten Filmframe-Mounter zusammengebaut.

Der Film 3 und der Innenumfang 1i des Filmrahmens 1 bilden einen wannenförmigen Lösungsmittelbehälter 20, in welchem wie vorbeschrieben der Produktsubstrat-Trägersubstrat-Verbund anordenbar ist.

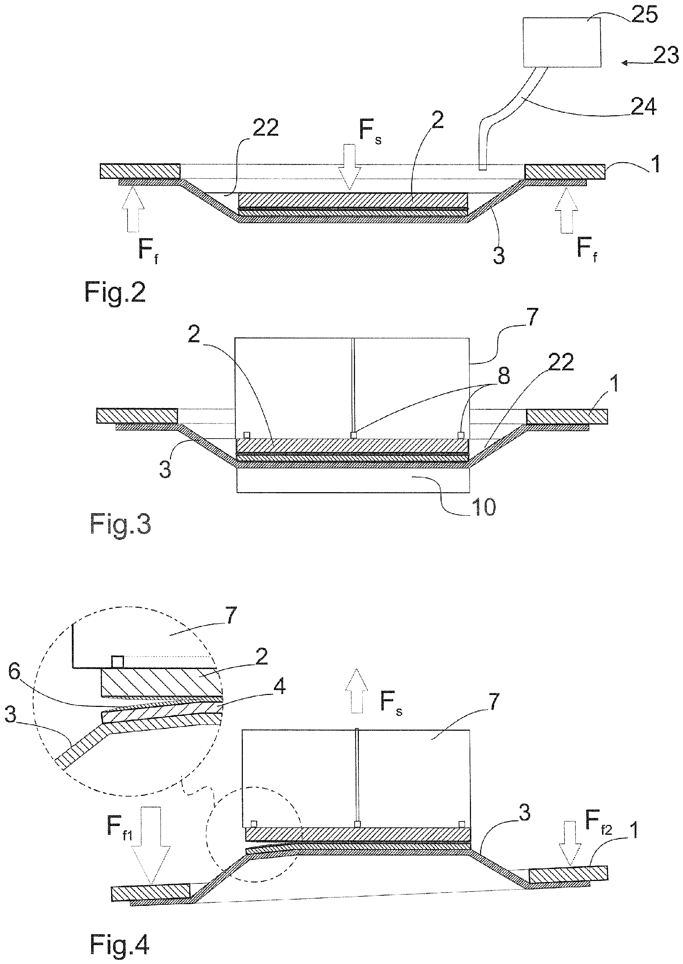

Gemäß dem in Figur 2 gezeigten Verfahrensschritt ist Lösungsmittel 22 durch Einbringmittel 23 in den Lösungsmittelbehälter 20 einbringbar. Die Einbringmittel 23 bestehen vorliegend aus einer Leitung 24 und einem Lösungsmittelvorrat 25, die von einer Zentraleinheit ansteuerbar sind, um Lösungsmittel 22 in den Lösungsmittelbehälter 20 einzubringen.

Wie in Figur 2 gezeigt, ist der Lösungsmittelbehälter 20 durch den zumindest im Ablöseabschnitt 3a elastischen Film 3 volumenveränderlich, indem eine Kraft Fₛ auf das Trägersubstrat 2 nach unten und eine Kraft F_{f} auf den Filmrahmen 1 nach oben wirkt. Die Krafteinbringung wird ebenfalls durch eine Zentraleinheit gesteuert.

Durch die Vergrößerung des Vorratsmittelbehältervolumens wird verhindert, dass Lösungsmittel 22 über den Rand des Filmrahmens 1 läuft und gleichzeitig wird eine schnelle Verteilung oder Einbringung des Lösungsmittels 22 ermöglicht.

Die Kraft Fₛ wird gemäß Figur 3 über eine Trägersubstrataufnahme 7 zur Aufnahme des Trägersubstrats 2 übertragen, wobei die Fixierung des Trägersubstrats 2 auf der Trägersubstrataufnahme 7 durch in die Oberfläche der Trägersubstrataufnahme 7 eingearbeitete Vakuumbahnen 8 und eine daran angeschlossene, nicht dargstellte Vakuumeinrichtung erfolgt.

Auf der gegenüberliegenden Seite des Films 3 zum Produktsubstrat 4 ist ein Schallwellenerzeuger 10, insbesondere zur Erzeugung von Ultraschallwellen, anordenbar, durch welchen Ultraschallwellen auf das Produktsubstrat 4, insbesondere jedoch auf die Verbindungsschicht 6 und das Lösungsmittel 22 übertragen werden können, da hierdurch der Vorgang des Lösens stark beschleunigt wird, insbesondere um eine Faktor 2, vorzugsweise um eine Faktor 5, noch bevorzugter um einen Faktor 10 bis 50.

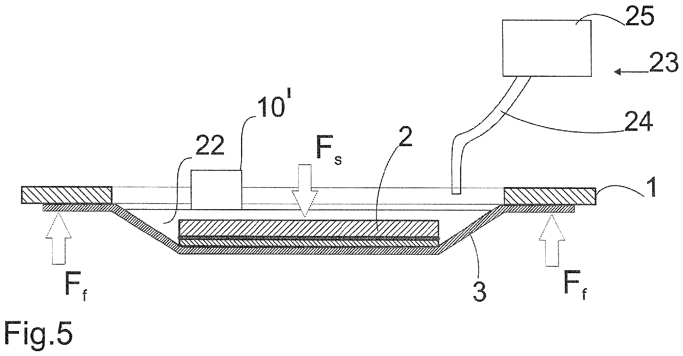

Gemäß einer alternativen, in Figur 5 gezeigten Ausführungsform ist der Schallwellenerzeuger 10' zumindest mit der Oberfläche des fluiden Lösungsmittels 22 in Kontakt, vorzugsweise aber in dieses zumindest teilweise eingetaucht. Hierdurch können die Schallwellen direkt auf das Lösungsmittel 22 und vom Lösungsmittel 22 auf die Verbindungsschicht 6 übertragen werden.

Die auf den Filmrahmen 1 wirkende Kraft F_{f} kann - wie in Figur 3 dargestellt - gleichmäßig verteilt als Flächenkraft auf den Filmrahmen 1 wirken, so dass über die Verformung des Films 3 im Ablöseabschnitt 3a die Volumenveränderung des Lösungsmittelbehälters 20 bewirkt werden kann.

Umgekehrt erfolgt gemäß Figur 4 das Ablösen des Produktsubstrats 2 vom Trägersubstrat 4, indem die Kräfte Fₛ und F_{f} beziehungsweise Fₛ₁ und Fₛ₂ in jeweils entgegengesetzter Richtung gerichtet werden, wobei die Kraft F_{f1} bei der hier gezeigten Ausführungsform größer als die Kraft F_{f2} eingestellt wird, um die Ablösung des Produktsubstrats 4 schonend zunächst von einer Randseite gemäß der in Figur 4 gezeigten Vergrößerung starten zu lassen.

Die Kraft F_{f1} beziehungsweise mehrere Kräfte F_{f1}, F_{f2} bis F_{fn} kann/können punktuell verteilt am Umfang des Filmrahmens 1 eingeleitet werden oder durch eine Filmrahmenaufnahme verteilt eingebracht werden.

Soweit die Kräfte F_{f1}, F_{f2} und/oder F_{fn} unterschiedlich ausgebildet sind, muss die Aufnahmeeinrichtung zur Einleitung der Kraft in den Filmrahmen 1 ein Kippen des Filmrahmens 1 zulassend ausgebildet sein.

Zwischen dem in Figur 3 dargestellten Verfahrensschritt des Lösens durch das Lösungsmittel 22 und dem in Figur 4 dargestellten Verfahrensschritt des Ablösens durch entgegengesetzte Kräfte Fₛ, F_{f1}, F_{f2}, F_{fn} kann ein Verfahrensschritt vorgesehen sein, durch den das Lösungsmittel 22 aus dem Lösungsmittelbehälter 20 entfernt wird, insbesondere durch Absaugen.

### Bezugszeichenliste

- 1: Filmrahmen
- 2: Trägersubstrat
- 3: Film
- 3a: Ablöseabschnitt
- 3b: Befestigungsabschnitt
- 3k: Kontaktierungsflächenabschnitt
- 3s: Klebeschicht
- 4: Produktsubstrat
- 4u: Umfang
- 6: Verbindungsschicht
- 7: Trägersubstrataufnahme
- 8: Vakuumbahnen
- 10, 10': Schallwellenerzeuger
- 20: Lösungsmittelbehälter
- 22: Lösungsmittel
- 23: Einbringmittel
- 24: Leitung
- 25: Lösungsmittelvorrat
- F_{f}, F_{f1,} F_{f2} ... F_{fn}: Kraft
- Fs: Kraft

## Patentansprüche

1. Vorrichtung zum Ablösen eines Produktsubstrats (4) von einem mit dem Produktsubstrat (4) durch eine Verbindungsschicht (6) verbundenen Trägersubstrat (2), wobei das Produktsubstrat (4) auf einem flexiblen Film (3) aufgenommen ist, der eine Klebeschicht (3s) zur Aufnahme des Produktsubstrats (4) in einem Kontaktierungsflächenabschnitt (3k) des Films (3) aufweist, und wobei der Film (3) in einem den Kontaktierungsflächenabschnitt (3k) umgebenden Befestigungsabschnitt (3b) des Films (3) mit einem Filmrahmen (1) verbunden ist, mit:
- Ablösemitteln zur Ablösung des Produktsubstrats (4) vom Trägersubstrat (2) durch eine auf das Trägersubstrat (2) wirkende Kraft Fs **dadurch gekennzeichnet, dass** mindestens zwei, an seinem Umfang auf den Filmrahmen (1) wirkende, über den Umfang verteilte, unterschiedlich steuerbare Kräfte F_{f1} und F_{f2} der Kraft F_{S} entgegen gerichtet anlegbar sind.

2. Vorrichtung nach Anspruch 1,
**dadurch gekennzeichnet,**
**dass** der Film (3), insbesondere durch die Kraft Fs und die Kraft Ff, in einem zwischen dem Kontaktierungsflächenabschnitt (3k) und dem Befestigungsabschnitt (3b) liegenden Ablöseabschnitt (3a) spannbar ist.

3. Vorrichtung nach einem der vorhergehenden Ansprüche,
**dadurch gekennzeichnet,**
**dass** die Ablösemittel konzentrisch vom Umfang (4u) des Produktsubstrats (4) zum Zentrum (4z) des Produktsubstrats (4) wirkend ausgebildet sind.

4. Verfahren zum Ablösen eines Produktsubstrats (4) von einem mit dem Produktsubstrat (4) durch eine Verbindungsschicht (6) verbundenen Trägersubstrat (2), wobei das Produktsubstrat (4) auf einem flexiblen Film (3) aufgenommen ist, der eine Klebeschicht (3s) zur Aufnahme des Produktsubstrats (4) in einem Kontaktierungsflächenabschnitt (3k) des Films (3) aufweist, und wobei der Film (3) in einem den Kontaktierungsflächenabschnitt (3k) umgebenden Befestigungsabschnitt (3b) des Films (3) mit einem Filmrahmen (1) verbunden ist, mit folgendem Schritt:
- Ablösung des Produktsubstrats (4) vom Trägersubstrat (2) durch eine auf das Trägersubstrat (2) wirkende Kraft Fs **dadurch gekennzeichnet, dass** mindestens zwei auf den Filmrahmen (1) wirkende, über den Umfang verteilte, unterschiedlich steuerbare Kräfte F_{f1} und F_{f2} entgegen der Kraft F_{S} gerichtet wirken.

5. Verfahren nach Anspruch 4,
**dadurch gekennzeichnet,**
**dass** die Ablösung des Produktsubstrats (4) konzentrisch vom Umfang (4u) des Produktsubstrats (4) zum Zentrum (4z) des Produktsubstrats (4) erfolgt.

6. Verfahren nach einem der Ansprüche 4 oder 5,
**dadurch gekennzeichnet,**
**dass** das Produktsubstrats (4) mit dem Trägersubstrat (2) über eine verschiedene Kleber umfassende Verbindungsschicht verbunden wird.

## Claims

1. Device for stripping a product substrate (4) off a carrier substrate (2) connected to the product substrate (4) by a bonding layer (6), wherein the product substrate (4) is received on with a flexible film (3) which has an adhesive layer (3s) for holding the product substrate (4) in a contacting surface section (3k) of the film (3), and wherein the film (3) being connected to a film frame (1) in an attachment section (3b) of the film (3) which surrounds the contacting surface section (3k), with the following features:
- stripping means for stripping the product substrate (4) off the carrier substrate (2) by means of a force Fs,
**characterized in that** at least two differently controllable forces F_{F1} and F_{F2} acting on the periphery of film frame (1) and distributed over the periphery are applicable in opposed directions.

2. Device as claimed in claim 1, wherein the film (3) can be clamped, especially by the force Fs and force Ff, in a stripping section (3a) which lies between the contacting surface section (3k) and the attachment section (3b).

3. Device as claimed in one of the preceding claims, wherein the stripping means are made to act concentrically from the periphery (4u) of the product substrate (4) to the center (4z) of the product substrate (4).

4. Method for stripping a product substrate (4) off a carrier substrate (2) connected with the product substrate (4) by means of a bonding layer (6), wherein the product substrate (4) is received on with a flexible film (3) which has an adhesive layer (3s) for holding the product substrate (4) in a contacting surface section (3k) of the film (3), and wherein the film (3) being connected to a film frame (1) in an attachment section (3b) of the film (3) which surrounds the contacting surface section (3k), with the following steps:
- detaching the product substrate (4) from the carrier substrate (2) by means of a force Fs, **characterized in that** at least two differently controllable forces F_{F1} and F_{F2} acting on the periphery of film frame (1) and distributed over the periphery are applied in opposed directions.

5. Method as claimed in Claim 4, wherein the stripping means is effected concentrically from the periphery (4u) of the product substrate (4) to the center (4z) of the product substrate (4).

6. Method as claimed in Claim 4 or 5, wherein the product substrate (4) is bonded to the carrier substrate (2) by means of a bonding layer containing different adhesives.

## Revendications

1. Dispositif pour séparer un substrat de produit (4) d'un substrat porteur (2) relié au substrat de produit (4) par une couche de liaison (6), dans lequel le substrat de produit (4) est reçu sur un film flexible (3) qui présente une couche adhésive (3s) pour recevoir le substrat de produit (4) dans un tronçon de surface de contact (3k) du film (3), et dans lequel le film (3) est relié à un cadre de film (1) dans un tronçon de fixation (3b) du film (3) entourant le tronçon de surface de contact (3k), comprenant :
- des décapants pour séparer le substrat de produit (4) du substrat porteur (2) par une force Fs agissant sur le substrat porteur (2), **caractérisé en ce qu'**au moins deux forces Ff₁ et Ff₂ pouvant être commandées de façon différente, réparties sur le pourtour, agissant sur le cadre de film (1) sur son pourtour, peuvent être appliquées en étant dirigées de façon opposée à la force Fs.

2. Dispositif selon la revendication 1,
**caractérisé en ce que**
le film (3), en particulier par la force Fs et la force Ff, peut être tendu dans un tronçon de séparation (3a) situé entre le tronçon de surface de contact (3k) et le tronçon de fixation (3b).

3. Dispositif selon l'une des revendications précédentes, **caractérisé en ce que**
les décapants sont conçus pour agir de façon concentrique à partir du pourtour (4u) du substrat de produit (4) vers le centre (4z) du substrat de produit (4).

4. Procédé pour séparer un substrat de produit (4) d'un substrat porteur (2) relié au substrat de produit (4) par une couche de liaison (6), dans lequel le substrat de produit (4) est reçu sur un film flexible (3) qui présente une couche adhésive (3s) pour recevoir le substrat de produit (4) dans un tronçon de surface de contact (3k) du film (3), et dans lequel le film (3) est relié à un cadre de film (1) dans un tronçon de fixation (3b) du film (3) entourant le tronçon de surface de contact (3k), comprenant l'étape suivante :
- séparation du substrat de produit (4) du substrat porteur (2) par une force Fs agissant sur le substrat porteur (2), **caractérisé en ce qu'**au moins deux forces Ff₁ et Ff₂ de la force Fs pouvant être commandées de façon différente, réparties sur le pourtour, agissant sur le cadre de film (1), agissent en étant dirigées de façon opposée à la force Fs.

5. Procédé selon la revendication 4,
**caractérisé en ce que**
la séparation du substrat de produit (4) est effectuée de façon concentrique à partir du pourtour (4u) du substrat de produit (4) vers le centre (4z) du substrat de produit (4).

6. Procédé selon la revendication 4 ou 5,
**caractérisé en ce que**
le substrat de produit (4) est relié au substrat porteur (2) par une couche de liaison comprenant différentes colles.
